# EUROPÄISCHE PATENTSCHRIFT

(11) **EP 1 001 312 B1**
(45) Veröffentlichungstag und Bekanntmachung des Hinweises auf die Patenterteilung: **31.07.2002**
(21) Anmeldenummer: 99122109.4
(22) Anmeldetag: 05.11.1999
(51) Int. Cl.: G03F 7/021, G03F 7/075

(54) **Strahlungsempfindliches Aufzeichnungsmaterial zur Herstellung von Wasserlos-Offsetdruckplatten**
Radiation sensitive recording material for the production of dry offset printing plates
Matériau d'enregistrement sensible aux radiations pour la fabrication de plaques d'impression offset à sec

(30) Priorität: 11.11.1998 DE 19852258
(43) Veröffentlichungstag der Anmeldung: 17.05.2000
(73) Patentinhaber: AGFA-GEVAERT, 2640 Mortsel (BE)
(72) Erfinder: Gries, Willi-Kurt, Dr., 55252 Mainz-Kastel (DE); Schlosser, Hans-Joachim, Dr., 65207 Wiesbaden (DE)

(56) Entgegenhaltungen:
- EP-A- 0 394 923
- EP-A- 0 741 334
- GB-A- 1 447 886
- GB-A- 2 277 601

## Beschreibung

Die Erfindung betrifft ein Aufzeichnungsmaterial mit - in dieser Reihenfolge - einem Träger, einer strahlungsempfindlichen Schicht und einer Silikonschicht. Sie betrifft daneben ein Verfahren zur Herstellung einer Druckplatte für den wasserlosen Offsetdruck aus dem Aufzeichnungsmaterial.

Aufzeichnungsmaterialien, aus denen sich Wasserlos-Offsetdruckplatten herstellen lassen, sind bereits bekannt. So ist in der GB 1 399 949 ein positivarbeitendes Material mit einem Träger, einer Druckfarbe annehmenden strahlungsempfindlichen Schicht, einer Druckfarbe abstoßenden Silikonschicht und vorzugsweise noch einem transparenten Schutzfilm offenbart. Die strahlungsempfindliche Schicht enthält als wesentliche Bestandteile ein photopolymerisierbares, ethylenisch ungesättigtes Monomer oder Oligomer mit einem Siedepunkt von mehr als 100 °C, einen Photoinitiator sowie im allgemeinen auch ein Bindemittel. Das Bindemittel ist bevorzugt ein Vinylpolymer oder -copolymer (wie Polyvinylacetat, Polyvinylalkohol, Polyvinylbutyral, Polyvinylbutylether, Polyvinylchlorid oder Polyethylen), Polyether (wie Polyethylenoxid oder Polypropylenoxid), Polyamid, Polyester, ein Cellulose-Derivat, ein Hamstoff/Formaldehyd-Harz, ein Alkydharz, ein Melamin/Formaldehyd- oder ein Phenol/Formaldehyd-Harz. In den belichteten Bereichen der strahlungsempfindlichen Schicht ist das Monomer oder Oligomer polymerisiert und haftet dadurch an der Silikonschicht. Das Aufzeichnungsmaterial wird dann mit einer Entwicklerlösung behandelt. Dabei wird die Silikonschicht in den nichtbelichteten Bereichen stärker angequollen und kann durch Bürsten oder ähnliche Maßnahmen entfernt werden. In den bestrahlten Bereichen bleibt die Silikonschicht dagegen auf der lichtempfindlichen Schicht haften. Durch Erhitzen oder vollflächiges Belichteten kann die Haftung zwischen lichtempfindlicher Schicht und Silikonschicht noch verstärkt werden. Gleichzeitig wird dadurch die lichtempfindliche Schicht in den ursprünglich nicht belichteten Bereichen gehärtet, was die Kratzempfindlichkeit der Wasserlos-Druckplatte vermindert und eine höhere Druckauflage zuläßt.

Das Aufzeichnungsmaterial gemäß der EP-A 0 394 923 umfaßt ebenfalls einen Träger, eine lichtempfindliche Schicht und eine Silikonschicht. Hier ist die lichtempfindliche Komponente ein Diazoniumsalz-Polykondensationsprodukt. Als weitere wesentliche Komponente enthält die lichtempfindliche Schicht ein polymeres Bindemittel mit Einheiten aus einem Ester, der aliphatische Hydroxygruppen enthält, oder aus einem Amid der Acryl- oder Methacrylsäure. Es ist allgemein ein Polymer mit Einheiten aus einem Hydroxyalkyl-(meth)acrylat oder -(meth)acrylamid. Es kann daneben auch Einheiten aus anderen Monomeren enthalten. Beispiele dafür sind Monomere mit aromatischen Hydroxygruppen (wie N-(4-Hydroxy-phenyl)-acrylamid oder-methacrylamid, 2-, 3- oder 4-Hydroxy-styrol, (2-, 3- oder 4-Hydroxy-phenyl)-acrylat oder -methacrylat). Daneben können solche Monomere auch α,β-ungesättigten Carbonsäuren, substituierte Alkylacrylaten oder -methacrylate, Vinylether (wie Ethyl-vinyl-ether, Butyl-vinyl-ether oder Phenyl-vinyl-ether), Styrole, Vinylketone, Olefine, N-Vinylpyrrolidon, N-Vinyl-carbazol, 4-Vinyl-pyridin, Acrylnitril oder Methacrylnitril sein. Der Anteil an Hydroxygruppen in dem Bindemittel (gemeint ist offenbar der Anteil an Einheiten, die aliphatische Hydroxygruppen enthalten) soll 5 bis 100 Gew.-%, bevorzugt 20 bis 100 Gew.-%, betragen, da sonst die Haftung zwischen strahlungsempfindlicher Schicht und Silikonschicht unzureichend ist. Nach der bildmäßigen Belichtung wird das Aufzeichnungsmaterial mit einer wäßrigen Lösung entwickelt, die polare Lösemittel (wie Alkohole, Ethylenglykol-monoalkylether, Ketone oder Ester), alkalisch reagierende Verbindungen, oberflächenaktive Mittel und aliphatische, aromatische oder halogenierte Kohlenwasserstoffe (wie Hexan, Heptan, Toluol oder Xylol) enthält. Dabei werden die unbestrahlten Bereiche der strahlungsempfindlichen Schicht zusammen mit den darüberliegenden Bereichen der Silikonschicht entfernt. Zwischen dem Aluminiumträger und der strahlungsempfindlichen Schicht ist dazu noch eine Grundierungsschicht (primer layer) angeordnet. Sie wird beim Entwickeln nicht mitentfernt. Beim Drucken wird die Farbe von der Primerschicht übertragen, während die stehengebliebenen Bereiche der Silikonschicht die Druckfarbe abstoßen.

Die bekannten Aufzeichnungsmaterialien für die Herstellung von Wasserlos-Druckplatten benötigen also organische Lösemittel bei der Entwicklung. Das ist aus Gründen der Arbeitssicherheit und des Umweltschutzes jedoch nachteilig. Die Entsorgung der verbrauchten Entwicklerlösungen ist zudem aufwendig und verursacht nicht unerhebliche Kosten.

Es stellte sich somit die Aufgabe, ein Aufzeichnungsmaterial mit möglichst einfachem Aufbau, d.h. mit wenigen Schichten, insbesondere ohne Grundierungsschicht, zu schaffen. Das bildmäßig bestrahlte Aufzeichnungsmaterial soll sich mit wäßrigen Lösungen, idealerweise mit reinem Wasser, zu einer Druckplatte entwickeln lassen, die beim Drucken kein Feuchtmittel benötigt (Wasserlos-Druckplatten). Darüber hinaus soll es so beschaffen sein, daß beim Entwickeln allein die Silikonschicht in den nichtbestrahlten Bereichen entfernt wird, nicht jedoch die (ehemals) strahlungsempfindliche Schicht. Beim Drucken soll die Farbe dementsprechend von den freigelegten Bereichen dieser Schicht übertragen und gleichzeitig eine Belastung des Entwicklers mit Bestandteilen der strahlungsempfindlichen Schicht vermieden werden, was gleichzeitig eine längere Standzeit des Entwicklers bedeutet.

Gelöst wird die Aufgabe durch ein Aufzeichnungsmaterial der eingangs genannten Art, das dadurch gekennzeichnet ist, daß die strahlungsempfindliche Schicht als strahlungsempfindliche Komponente ein Diazoniumsalz-Polykondensationsprodukt und als Bindemittel ein Homo- und/oder Copolymer enthält, das aus (C₁-C₁₂)Alkyl-vinyl-ether-Einheiten besteht bzw. mindestens 5 mol-% an solchen Einheiten umfaßt, dabei jedoch keine aliphatischen Hydroxygruppen aufweist. Besonders bevorzugt sind Polymere aus bzw. mit Methyl-vinyl-ether-Einheiten. Dabei haben die Homopolymere vorzugsweise einen K-Wert von 10 bis 80. Die Copolymere haben allgemein einen statistischen oder alternierenden Aufbau, sind also keine Blockcopolymere. Mit besonderem Vorteil handelt es sich bei den weiteren Einheiten in den Copolymeren um Einheiten aus Maleinsäureanhydrid oder aus Maleinsäure-monoalkylestern, insbesondere um Einheiten aus Maleinsäure-mono(C₁-C₆)alkylestern, wie Maleinsäure-monoethylester, -monoisopropylester oder -monobutylester. Methyl-vinyl-ether/Maleinsäureanhydrid-Copolymere sind beispielsweise unter der Bezeichnung ®Gantrez AN (CAS-Nr. 108-88-3) von GAF Chemicals Corp., USA, erhältlich.

Der Träger ist meist eine Metallplatte oder -folie. Bevorzugt sind Platten oder Folien aus Aluminium oder einer seiner Legierungen. Es hat sich als günstig erwiesen, den Träger vorzubehandeln. Trägermaterialien auf Basis von Aluminium werden üblicherweise mechanisch und/oder elektrochemisch aufgerauht und gegebenenfalls anschließend anodisch oxidiert. Danach ist noch eine chemische Vorbehandlung, beispielsweise mit Polyvinylphosphonsäure, Silikaten, Phosphaten, Hexafluorozirkonaten oder hydrolysiertem Tetraethyl-orthosilikat, möglich. Da - im Gegensatz zu üblichen Flachdruckplatten - keine hydrophile Trägeroberfläche erforderlich ist, können auch Trägermaterialien wie Kupfer, Messing oder andere oleophile Metalle bzw. Metallegierungen verwendet werden, daneben auch Kunststoffe, wie Polyester, Polycarbonat, Polyimid oder Celluloseacetat.

Die als Bindemittel in der strahlungsempfindlichen Schicht verwendeten Polymere haben allgemein ein Molekulargewicht M_{w} im Bereich von 40.000 bis 2.000.000, bevorzugt 50.000 bis 1.000.000, besonders bevorzugt 80.000 bis 500.000. Der Anteil an Bindemitteln beträgt allgemein 5 bis 40 Gew.-% bezogen auf das Gesamtgewicht der nichtflüchtigen Bestandteile der strahlungsempfindlichen Schicht.

Das Gemisch enthält als strahlungsempfindliche Komponente ein Kondensationsprodukt eines aromatischen Diazoniumsalzes. Derartige Kondensationsprodukte sind bekannt und z.B. in der DE-A 12 14 086 (= US-A 3 235 384) beschrieben.

Sie werden im allgemeinen durch Kondensation einer mehrkernigen aromatischen Diazoniumverbindung, vorzugsweise von substituierten oder unsubstituierten Diphenylamin-4-diazoniumsalzen mit aktiven Carbonylverbindungen, vorzugsweise Methoxymethyl-diphenylether oder Formaldehyd, in stark saurem Medium, vorzugsweise konzentrierter Phosphorsäure, hergestellt.

In den US-A 3 867 147 und 4 021 243 sind weitere Kondensationsprodukte beschrieben, deren zusätzlich durch Kondensation entstandene Einheiten von Diazoniumsalzgruppen frei sind und vorzugsweise von aromatischen Aminen, Phenolen, Phenolethern, aromatischen Thioethern, aromatischen Kohlenwasserstoffen, aromatischen heterocyclischen Verbindungen oder organischen Säureamiden abgeleitet sind.

Die Diazoniumsalzeinheiten A-N₂X leiten sich bevorzugt von Verbindungen der Formel (R¹-R²-)ₚR³-N₂X ab. In dieser Formel bedeutet
- R¹: einen aromatischen Rest mit mindestens einer zur Kondensation mit aktiver Carbonylverbindung befähigten Position,
- R²: eine Einfachbindung oder eine der Gruppen -(CH₂)_{q}NR⁴-, -O-(CH₂)ᵣ-NR⁴-, -S-(CH₂)ᵣ-NR⁴-, -S-CH₂CO-NR⁴-, -O-R⁵-O-, -O-, -S- oder -CO-NR⁴-,
- R³: eine ggf. substituierte Phenylengruppe,
- R⁴: Wasserstoff, eine Alkylgruppe mit 1 bis 5 C-Atomen, eine Aralkylgruppe mit 7 bis 12 C-Atomen oder eine Arylgruppe mit 6 bis 12 C-Atomen,
- R⁵: eine Arylengruppe mit 6 bis 12 C-Atomen,
- p: eine ganze Zahl von 1 bis 3,
- q: eine Zahl von 0 bis 5,
- r: eine Zahl von 2 bis 5 und
- X: ein Anion, das eine Löslichkeit in Wasser oder geeigneten Solventien bewirkt.

Das Anion X ist vorzugsweise Chlorid, Suifat, Phosphat oder ein ggf. substituiertes Alkansulfonat mit 1-4 Kohlenstoffatomen, z.B. Methansulfonat oder Aminoalkansulfonat (EP-A 0 224 162), *p*-Toluolsulfonat, Mesitylensulfonat, Hexafluorophosphat oder ähnliche.

Bevorzugt werden Kondensationsprodukte, die sich von ggf. substituierten Diphenylamin-4-diazoniumsalzen, besonders den 3-Methoxy-diphenylamin-4-diazoniumsalzen, ableiten und von diesen die leicht zugänglichen Kondensationsprodukte mit Formaldehyd. Die Kondensation wird vorzugsweise in konzentrierter Schwefel-, Phosphor- oder Methansulfonsäure, insbesondere in Phosphorsäure durchgeführt. Zur Stabilisierung sind Schwefel-, Phosphor-, Methansulfon-, *p*-Toluolsulfon- und Citronensäure geeignet.

Der Anteil der strahlungsempfindlichen Komponente beträgt allgemein 20 bis 80 Gew.-%, bevorzugt 30 bis 70 Gew.-%, besonders bevorzugt 40 bis 65 Gew.-%,jeweils bezogen auf das Gesamtgewicht der nichtflüchtigen Bestandteile der strahlungsempfindlichen Schicht.

Gegebenenfalls kann die strahlungsempfindliche Schicht auch noch Farbstoffe, Weichmacher (wie Glycerin), andere polymere Bindemittel (auch solche mit aliphatischen Hydroxygruppen) und allgemein übliche Zusätze wie Verlaufsmittel und Beschichtungsadditive in untergeordneten Mengen enthalten. Der Anteil solcher Bestandteile beträgt allgemein bis zu 30 Gew.-%, bevorzugt bis zu 20 Gew.-%, jeweils bezogen auf das Gesamtgewicht der nichtflüchtigen Bestandteile der strahlungsempfindlichen Schicht.

Das Gewicht der strahlungsempfindlichen Schicht liegt allgemein bei etwa 0,5 bis 3,0 g/m², bevorzugt 0,8 bis 1,5 g/m².

Für die Silikonschicht eignet sich grundsätzlich jeder Silikonkautschuk, der ausreichend farbabweisend ist, um ein Drucken ohne Feuchtwasser zu erlauben.

Unter der Bezeichnung "Silikonkautschuk" soll hier entsprechend der Definition von Noll, "Chemie und Technologie der Silikone", Verlag Chemie, 1968, Seite 332, ein hochmolekulares, im wesentlichen lineares Diorganopolysiloxan verstanden werden. Für die vernetzten oder vulkanisierten Produkte wird dagegen die Bezeichnung "Silikongummi" verwendet. In jedem Fall wird eine Silikonkautschuklösung auf die strahlungsempfindliche Schicht aufgebracht, getrocknet und dabei vernetzt.

Die Silikonkautschuke können Ein- oder Mehrkomponentenkautschuke sein. Beispiele dafür sind in den DE-A 23 50 211, 23 57 871 und 23 59 102 zu finden. Bevorzugt sind Kondensations-Silikonkautschuke, beispielsweise Einkomponenten-Silikonkautschuke (RTV-1). Sie basieren üblicherweise auf Polydimethylsiloxanen, die an den Enden Wasserstoffatome, Acetyl-, Oxim-, Alkoxy- oder Aminogruppen oder andere funktionelle Gruppen tragen. Die Methylgruppen in der Kette können durch andere Alkylgruppen, Halogenalkylgruppen oder unsubstituierte bzw. substituierte Arylgruppen ersetzt sein. Die endständigen funktionellen Gruppen sind leicht hydrolysierbar und härten in Gegenwart von Feuchtigkeit in einer Zeitspanne von einigen Minuten bis zu wenigen Stunden aus.

Die Mehrkomponenten-Silikonkautschuke sind durch Addition oder Kondensation vernetzbar. Die additionsvernetzbaren Typen enthalten im allgemeinen zwei verschiedene Polysiloxane. Das eine Polysiloxan ist in einem Anteil von 70 bis 99 Gew.-% vorhanden und besitzt Alkylengruppen (speziell: Vinylgruppen), die an Siliciumatome der Hauptkette gebunden sind. Das andere ist in einem Anteil von 1 bis 10 Gew.-% vorhanden. Darin sind Wasserstoffatome direkt an Siliciumatome gebunden. Die Additionsreaktion erfolgt dann in Gegenwart von etwa 0,0005 bis 0,002 Gew.-% eines Platinkatalysators bei Temperaturen von mehr als 50 °C. Mehrkomponenten-Silikonkautschuke haben den Vorteil, daß sie bei höherer Temperatur (etwa 100 °C) sehr schnell vernetzen. Die Zeit, in denen sie sich verarbeiten lassen, die sogenannte "Topfzeit", ist dagegen häufig relativ kurz.

Die durch Kondensation vernetzbaren Gemische enthalten Diorganopolysiloxane mit reaktionsfähigen Endgruppen, wie Hydroxy- oder Acetoxygruppen. Diese werden mit Silanen oder Oligosiloxanen in Gegenwart von Katalysatoren vernetzt. Die Vernetzer haben einen Anteil von 2 bis 10 Gew.-%, bezogen auf das Gesamtgewicht der Silikonschicht. Die Katalysatoren haben einen Anteil von 0,01 bis 6 Gew.-%, wiederum bezogen auf das Gesamtgewicht der Silikonschicht. Auch diese Kombinationen reagieren relativ schnell und haben daher nur eine begrenzte Topfzeit.

Die Silikonschicht kann noch weitere Komponenten enthalten. Diese können zu einer zusätzlichen Vernetzung, einer besseren Haftung, einer mechanischen Verstärkung oder zur Einfärbung dienen. Die weiteren Komponenten haben einen Anteil von nicht mehr als 10 Gew.-%, bevorzugt nicht mehr als 5 Gew.-%, jeweils bezogen auf das Gesamtgewicht der Silikonschicht.

Ein bevorzugtes Gemisch besteht aus hydroxyterminierten Polydimethylsiloxanen, einer Silan-Vernetzungskomponente (insbesondere einem tetra- oder trifunktionellen Alkoxy-, Acetoxy-, Amido-, Amino-, Aminoxy-, Ketoxim- oder Enoxysilan), einem Vernetzungskatalysator (insbesondere einer Organozinnoder einer Organotitan-Verbindung) und gegebenenfalls weiteren Komponenten (insbesondere Organopolysiloxanverbindungen mit Si-H-Bindungen, Platinkatalysatoren für eine zusätzliche Additionsvernetzung, Silane mit haftverbessernden Eigenschaften, Reaktionsverzögerer, Füllstoffe und/oder Farbstoffe). Die genannten Silan-Vernetzungskomponenten und die bei der Vernetzung auftretenden Reaktionen sind von J. J. Lebrun und H. Porte in "Comprehensive Polymer Science", Vol. 5 [1989] 593 - 609, beschrieben.

Die Silikonkautschuke werden nach dem Aufbringen als Schicht in bekannter Weise durch Feuchtigkeitseinwirkung oder aus sich heraus bei Raumtemperatur oder bei erhöhter Temperatur zu einem in organischen Lösemitteln im wesentlichen unlöslichen Silikongummi vernetzt. Das Gewicht der fertigen Silikonschicht beträgt im allgemeinen 1,0 bis 5,0, bevorzugt von 1,2 bis 3,5, besonders bevorzugt 1,5 bis 3,0 g/m².

Auf der Silikonschicht kann sich gegebenenfalls eine diskontinuierliche Mattierungsschicht befinden. Sie dient zur Verbesserung des Kopierverhaltens, indem sie die Zeit bis zur Herstellung eines konstanten Vakuums im Vakuum-Kontaktkopierrahmen verkürzt. Wenn die Mattierungsschicht nicht vorhanden ist, können sich trotz Anlegen eines Vakuums zwischen der Filmvorlage und der (ebenfalls glatten) Silikonschicht Lufteinschlüsse halten, so daß der Abstand zwischen Vorlage und strahlungsempfindlicher Schicht nicht überall gleich ist. Beim nachfolgenden Bestrahlen können dann Fehler auftreten. Die Mattierungsschicht besteht allgemein aus einem wasserlöslichen organischen Polymer, beispielsweise Polyvinylpyrrolidon, Polyacrylsäure, Polyvinylbutyral, Polysaccharide Gelatine oder Polyvinylalkohol. Herstellen läßt sich die Mattierungsschicht nach allgemein bekannten Verfahren, beispielsweise durch Aufsprühen einer entsprechenden wäßrigen Lösung oder Dispersion und nachfolgendes Trocknen. Das Gewicht der Mattierungsschicht liegt allgemein bei 0,1 bis 0,5 g pro m² des Aufzeichnungsmaterials. Beim Entwickeln (bei Wasserlos-Druckplatten auch als "Entschichten" bezeichnet) mit Wasser wird die Mattierungsschicht vollständig entfernt.

Die bildmäßige Bestrahlung des Aufzeichnungsmaterial erfolgt in der Regel durch Kontaktbebilderung (dabei wird die Filmvorlage in einem Vakuum-Kontaktkopierrahmen unmittelbar auf das Aufzeichnungsmaterial gelegt und anschließend die dazwischen befindliche Luft abgesaugt) mit Lichtquellen, die üblicherweise für diesen Zweck verwendet werden, wie Quecksilber-Hochdruckdampflampen oder Kohlebogenlampen. Anschließend wird das bestrahlte Aufzeichnungsmaterial in einer für Wasserlos-Druckplatten üblichen und bekannten Vorrichtung mit Wasser oder einer wäßrigen Lösung entwickelt. Zweckmäßigerweise wird der Entwicklungsvorgang durch Bürsten oder auf andere Weise mechanisch unterstützt. Dabei wird die Silikonschicht in den Nichtbildbereichen entfernt. Gleichzeitig wird die auf der Silikonschicht gegebenenfalls vorhandene Abstandshalterschicht entfernt. Auf das Vorquellen des bestrahlten Aufzeichnungsmaterials kann sogar verzichtet werden. Die beim Entwickeln abgelösten Bestandteile der Silikonschicht lassen sich durch Filtration abtrennen. Es stellt sich also nicht das Problem der Entsorgung von mit Chemikalien belasteten, verbrauchten Entwicklerlösungen.

Die aus dem erfindungsgemäßen, positiv-arbeitenden Aufzeichnungsmaterial hergestellten Druckformen für den wasserlosen Offsetdruck zeigen eine hohe Auflösung und erlauben gleichzeitig eine hohe Druckauflage.

Die nachfolgenden Beispiele dienen zur Erläuterung der Erfindung. Darin steht "Gt" für "Gewichtsteil(e)". Prozente sind Gewichtsprozente, soweit nicht anders angegeben.

### Beispiele 1 bis 7:

Eine 0,3 mm dicke, elektrolytisch aufgerauhte und anodisch oxidierte Aluminiumplatte mit einem Oxidgewicht von 3,6 g/m² (± 0,3 g/m²) wurde mit einer 0,1 %igen wäßrigen Polyvinylphosphonsäure-Lösung hydrophiliert. Auf dieses Trägermaterial wurde eine Lösung aus
- 2,65 Gt: eines Diazoniumsalz-Polykondensationsproduktes aus 1 mol 3-Methoxy-diphenylamin-4-diazoniumsulfat und 1 mol 4,4'-Bis-methoxymethyl-diphenylether, isoliert als Mesitylensulfonat,
- 0,08 Gt: 85 %iger Phosphorsäure,
- 0,40 Gt: Glycerin,
- 0,84 Gt: eines der in der folgenden Tabelle aufgeführten Bindemittel (bei den gelösten Bindemitteln beziehen sich die Gt auf den Feststoffanteil; das Lösemittel wird dabei berücksichtigt und entsprechend reduziert),
- 2,40 Gt: einer 1%igen Silikonöl-Lösung in Diethylenglykol-monomethylether (= Methyldiglykol),
- 36,48 Gt: Ethanol (bei Verwendung von Bindemittel, die bereits in Alkoholen gelöst sind, wurde dieser Anteil entsprechend vermindert),
- 41,78 Gt: Diethylenglykol-monomethylether und
- 15,36 Gt: Butan-2-on (= Methyl-ethyl-keton)
aufgeschleudert. Die Beschichtung wurde dann 2 min lang bei 120 °C im Umluftofen getrocknet. Die Dicke der auf diese Weise hergestellten strahlungsempfindlichen Schichten ist ebenfalls in Tabelle 1 angegeben.

**Tabelle:**

| Beispiel | Art des Bindemittels | Schichtdicke [g/qm] |
|---|---|---|
| 1 | Methylvinylether/Malelnsäureanhydrid-Copolymer (alternierender Aufbau; M_{w}: 216.000; 10 %ige Lösung in Ethanol) | 1,03 |
| 2 | Poly(methylvinylether), K-Wert = 50 | 0,85 |
| 3 | Poly(ethylvinylether), K-Wert = 12 | 0,75 |
| 4 | Monoethylester eines Methylvinylether/Maleinsäure-Copolymers (M_{w}: 100.000 bis 150.000; 50 %ige Lösung in Ethanol) | 0,89 |
| 5 | Monoisopropylester eines Methylvinylether/Maleinsäure-Copolymers (M_{w}: 110.000 bis 140.000; 50 %ige Lösung in Isopropanol) | 0,88 |
| 6 | Monobutylester eines Methylvinylether/Maleinsäure-Copolymers (M_{w}: 90.000 bis 150.000; 50 %ige Lösung in Ethanol) | 0,90 |
| 7 | Methylvinylether/Maleinsäure-Copolymer (M_{w}: 1.980.000) | 1,32 |

Auf die strahlungsempfindliche Schicht wurde dann mit einem Gemisch aus
- 8,42 Gt: eines hydroxy-terminierten Polydimethylsiloxans mit einer Viskosität von etwa 5 000 mP s,
- 0,58 Gt: Ethyl-triacetoxy-silan,
- 0,09 Gt: einer 1%igen Lösung von Dibutylzinnacetat in einem isoparaffinischen Kohlenwasserstoff-Gemisch mit einem Siedebereich von 117 bis 134 °C,
- 27,30 Gt: Butan-2-on und
- 63,61 Gt: des isoparaffinischen Kohlenwasserstoff-Gemisches mit einem Siedepunkt von 117 bis 134 °C
beschichtet. Die so erzeugte Schicht wurde 2 min lang bei 120 °C getrocknet. Die Dicke der Silikonschicht betrug danach 2,1 g/m².

Das auf diese Weise hergestellte Aufzeichnungsmaterial wurde anschließend 38 s lang unter einer Positiv-Vorlage mit einer 5 kW-Metallhalogenidlampe im Abstand von 110 cm bildmäßig belichtet. Danach wurde es in einer für die Entwicklung von Wasserlos-Druckplatten gebräuchlichen Anlage entwickelt (darin wird die Schicht mit mechanischer Unterstützung entwickelt). In der Vorquellstufe dieser Anlage wurde normales Wasser von etwa Raumtemperatur verwendet. In den nicht von der Strahlung getroffenen Bereichen war dann die Silikonkautschukschicht entfernt, die strahlungsempfindliche Schicht jedoch im wesentlichen auf dem Träger verblieben. Die dabei erhaltene Druckform zeigte eine hohe Auflösung sowie eine hohe Stabilität beim Drucken, so daß auch höhere Druckauflagen möglich waren.

### Beispiel 8 (Vergleichsbeispiel)

Wie in dem Beispielen 1 bis 7 beschrieben, wurde ein strahlungsempfindliches Aufzeichnungsmaterial mit einer Silikonschicht hergestellt. Die strahlungsempfindliche Schicht wurde diesmal jedoch hergestellt mit einem Gemisch aus
- 2,67 Gt: Diazonium-Polykondensationsprodukt aus 1 mol 3-Methoxy-diphenylamin-4-diazoniumsulfat und 1 mol 4,4'-Bis-methoxymethoxydiphenylether, isoliert als Mesitylensulfonat,
- 0,10 Gt: 85 %ige Phosphorsäure,
- 1,00 Gt: Glycerin,
- 1,06 Gt: Polyvinylbutyral (80 mol-% Vinylbutyral-Einheiten, 18 mol-% Vinylalkohol-Einheiten und 2 mol-% Vinylacetat-Einheiten; T_{g} = 72 bis 78 °C),
- 0,15 Gt: Victoriablau FBR (Basic Blue 55),
- 3,00 Gt: einer 1 %igen Lösung eines Silikonöls (^{(R)}Edaplan LA 411) in Diethylenglykol-monomethylether,
- 36,10 Gt: Ethanol,
- 40,73 Gt: Ethylenglykol-monomethylether und
- 15,20 Gt: Butan-2-on.

Nach dem Trocknen hatte die daraus hergestellte strahlungsempfindliche Schicht eine Dicke von 1,1 g/m².

Das Aufzeichnungsmaterial wurde wie in den erfindungsgemäßen Beispielen bildmäßig belichtet und entwickelt. Dabei konnte die Silikonschicht in den nicht bestrahlten Bereichen des Aufzeichnungsmaterials jedoch nicht entfernt werden, so daß keine brauchbare Druckform erhalten wurde.

### Beispiel 9 (Vergleichsbeispiel)

Beispiel 8 wurde wiederholt mit der einzigen Abweichung, daß das Polyvinylbutyral durch eine gleiche Menge eines Umsetzungsprodukts aus Polyvinylbutyral und Maleinsäureanhydrid (wie in der DE-A 34 04 366 beschrieben) ersetzt worden war und daß die Dicke der strahlungsempfindlichen Schicht 1,0 g/m² betrug.

## Patentansprüche

1. Aufzeichnungsmaterial mit einem Träger, einer strahlungsempfindlichen Schicht und einer Silikonschicht, **dadurch gekennzeichnet, daß** die strahlungsempfindliche Schicht als strahlungsempfindliche Komponente ein Diazoniumsalz-Polykondensationsprodukt und als Bindemittel ein Homo- und/oder Copolymer enthält, das aus (C₁-C₁₂)Alkyl-vinyl-ether-Einheiten besteht oder mindestens 5 mol-% an solchen Einheiten umfaßt, dabei jedoch keine aliphatischen Hydroxygruppen aufweist.

2. Aufzeichnungsmaterial gemäß Anspruch 1, **dadurch gekennzeichnet, daß** der Anteil der strahlungsempfindlichen Komponente 20 bis 80 Gew.-%, bevorzugt 30 bis 70 Gew.-%, besonders bevorzugt 40 bis 65 Gew.-%, ,jeweils bezogen auf das Gesamtgewicht der nichtflüchtigen Bestandteile der strahlungsempfindlichen Schicht, beträgt.

3. Aufzeichnungsmaterial gemäß Anspruch 1, **dadurch gekennzeichnet, daß** das Bindemittel ein Homopolymer aus bzw. ein Copolymer mit Methylvinyl-ether-Einheiten ist.

4. Aufzeichnungsmaterial gemäß einem der Ansprüche 1 bis 3, **dadurch gekennzeichnet, daß** die weiteren Einheiten in dem Copolymer Einheiten aus Maleinsäureanhydrid oder aus Maleinsäure-monoalkylestern, insbesondere Einheiten aus Maleinsäure-mono(C₁-C₆)alkylestern, wie Maleinsäure-monoethylester, -monoisopropylester oder -monobutylester, sind.

5. Aufzeichnungsmaterial gemäß einem oder mehreren der Ansprüche 1 bis 4, **dadurch gekennzeichnet, daß** das als Bindemittel in der strahlungsempfindlichen Schicht verwendete Homo- oder Copolymer ein Molekulargewicht M_{w} im Bereich von 40.000 bis 2.000.000, bevorzugt 50.000 bis 1.000.000, besonders bevorzugt 80.000 bis 500.000, aufweist.

6. Aufzeichnungsmaterial gemäß einem oder mehreren der Ansprüche 1 bis 5, **dadurch gekennzeichnet, daß** der Bindemittelanteil 5 bis 40 Gew.-%, bezogen auf das Gesamtgewicht der nichtflüchtigen Bestandteile der strahlungsempfindlichen Schicht, beträgt.

7. Aufzeichnungsmaterial gemäß einem oder mehreren der Ansprüche 1 bis 6, **dadurch gekennzeichnet, daß** das Diazoniumsalz-Polykondensationsprodukt durch Kondensation einer mehrkernigen aromatischen Diazoniumverbindung, vorzugsweise eines substituierten oder unsubstituierten Diphenylamin-4-diazoniumsalzes, mit einer aktiven Carbonylverbindung, vorzugsweise Methoxymethyl-diphenylether oder Formaldehyd, erhalten wird.

8. Aufzeichnungsmaterial gemäß einem oder mehreren der Ansprüche 1 bis 7, **dadurch gekennzeichnet, daß** die strahlungsempfindliche Schicht zusätzlich noch Farbstoffe oder Weichmacher, vorzugsweise Glycerin, enthält.

9. Aufzeichnungsmaterial gemäß einem oder mehreren der Ansprüche 1 bis 8, **dadurch gekennzeichnet, daß** das Gewicht der strahlungsempfindlichen Schicht bei 0,5 bis 3,0 g/m², bevorzugt 0,8 bis 1,5 g/m², liegt.

10. Aufzeichnungsmaterial gemäß einem oder mehreren der Ansprüche 1 bis 9, **dadurch gekennzeichnet, daß** die Silikonschicht einen Kondensations-Silikonkautschuk umfaßt.

11. Aufzeichnungsmaterial gemäß einem oder mehreren der Ansprüche 1 bis 10, **dadurch gekennzeichnet, daß** das Gewicht der Silikonschicht 1,0 bis 5,0, bevorzugt von 1,2 bis 3,5, besonders bevorzugt 1,5 bis 3,0 g/m², beträgt.

12. Aufzeichnungsmaterial gemäß einem oder mehreren der Ansprüche 1 bis 11, **dadurch gekennzeichnet, daß** sich auf der Silikonschicht eine diskontinuierliche Mattierungsschicht befindet.

13. Aufzeichnungsmaterial gemäß Anspruch 12, **dadurch gekennzeichnet, daß** die Mattierungsschicht aus einem wasserlöslichen organischen Polymer, bevorzugt Polyvinylpyrrolidon, Polyacrylsäure, Polyvinylbutyral, Polysaccharide, Gelatine oder Polyvinylalkohol, besteht.

14. Aufzeichnungsmaterial gemäß einem oder mehreren der Ansprüche 1 bis 13, **dadurch gekennzeichnet, daß** der Träger aus Aluminium oder einer Aluminiumlegierung besteht und seine Oberfläche elektrochemisch aufgerauht ist.

15. Verfahren zur Herstellung einer Druckform für den wasserlosen Offsetdruck, **dadurch gekennzeichnet, daß** ein Aufzeichnungsmaterial gemäß einem oder mehreren der Ansprüche 1 bis 14 bildmäßig belichtet und anschließend mit Wasser oder einer wäßrigen Lösung entwickelt wird.

## Claims

1. Recording material having a support, a radiation-sensitive layer and a silicone layer, **characterized in that** the radiation-sensitive layer contains, as radiation-sensitive component, a diazonium salt polycondensation product and, as binder, a homopolymer and/or copolymer which consists of (C₁-C₁₂)alkyl vinyl ether units or includes at least 5 mol-% of such units, but at the same time contains no aliphatic hydroxyl groups.

2. Recording material according to Claim 1, **characterized in that** the proportion of the radiation-sensitive component is from 20 to 80% by weight, preferably from 30 to 70% by weight, particularly preferably from 40 to 65% by weight, in each case based on the total weight of the non-volatile constituents of the radiation-sensitive layer.

3. Recording material according to Claim 1, **characterized in that** the binder is a homopolymer of methyl vinyl ether units or a copolymer containing methyl vinyl ether units.

4. Recording material according to one of Claims 1 to 3, **characterized in that** the further units in the copolymer are units of maleic anhydride or monoalkyl maleates, in particular units of mono(C₁-C₆)alkyl maleates, such as monoethyl, monoisopropyl or monobutyl maleate.

5. Recording material according to one or more of Claims 1 to 4, **characterized in that** the homopolymer or copolymer used as binder in the radiation-sensitive layer has a molecular weight M_{w} in the range from 40,000 to 2,000,000, preferably from 50,000 to 1,000,000, particularly preferably from 80,000 to 500,000.

6. Recording material according to one or more of Claims 1 to 5, **characterized in that** the proportion of binders is from 5 to 40% by weight, based on the total weight of the non-volatile constituents of the radiation-sensitive layer.

7. Recording material according to one or more of Claims 1 to 6, **characterized in that** the diazonium salt polycondensation product is obtained by condensation of a polycyclic aromatic diazonium compound, preferably of a substituted or unsubstituted diphenylamine-4-diazonium salt, with an active carbonyl compound, preferably methoxymethyldiphenyl ether or formaldehyde.

8. Recording material according to one or more of Claims 1 to 7, **characterized in that** the radiation-sensitive layer additionally contains dyes or plasticizers, preferably glycerol.

9. Recording material according to one or more of Claims 1 to 8, **characterized in that** the weight of the radiation-sensitive layer is from about 0.5 to 3.0 g/m², preferably from 0.8 to 1.5 g/m².

10. Recording material according to one or more of Claims 1 to 9, **characterized in that** the silicone layer includes a condensation silicone rubber.

11. Recording material according to one or more of Claims 1 to 10, **characterized in that** the weight of the silicone layer is from 1.0 to 5.0 g/m², preferably from 1.2 to 3.5 g/m², particularly preferably from 1.5 to 3.0 g/m².

12. Recording material according to one or more of Claims 1 to 11, **characterized in that** a discontinuous matting layer is present on the silicone layer.

13. Recording material according to Claim 12, **characterized in that** the matting layer consists of a water-soluble organic polymer, preferably polyvinylpyrrolidone, polyacrylic acid, polyvinylbutyral, polysaccharides, gelatin or polyvinyl alcohol.

14. Recording material according to one or more of Claims 1 to 13, **characterized in that** the support consists of aluminium or an aluminium alloy and has been electrochemically roughened on its surface.

15. Process for the production of a printing plate for water-free offset printing, **characterized in that** a recording material according to one or more of Claims 1 to 14 is exposed imagewise and subsequently developed using water or an aqueous solution.

## Revendications

1. Matériau d'enregistrement comportant un support, une couche sensible aux radiations et une couche à base de silicone, **caractérisé en ce que** la couche sensible aux radiations contient en tant que composant sensible aux radiations un produit de polycondensation de sel de diazonium et, en tant que liant, un homo- et/ou copolymère qui consiste en motifs éther alkyl(C₁-C₁₂)-vinylique ou comprend au moins 5 % en moles de tels motifs, mais ne comporte en outre aucun groupe hydroxy aliphatique.

2. Matériau d'enregistrement selon la revendication 1, **caractérisé en ce que** la proportion du composant sensible aux radiations va de 20 à 80 % en poids, de préférence, de 30 à 70 % en poids, de façon particulièrement préférée, de 40 à 65 % en poids, dans chaque cas par rapport au poids total des composants non volatils de la couche sensible aux radiations.

3. Matériau d'enregistrement selon la revendication 1, **caractérisé en ce que** le liant est un homopolymère constitué de ou un copolymère comprenant des motifs éther méthylvinylique.

4. Matériau d'enregistrement selon l'une quelconque des revendications 1 à 3, **caractérisé en ce que** les autres motifs dans le copolymère sont des motifs d'anhydride maléique ou d'esters monoalkyliques d'acide maléique, en particulier des motifs d'esters monoalkyliques en C₁-C₆ d'acide maléique, tels que le maléate de monoéthyle, mono-isopropyle ou monobutyle.

5. Matériau d'enregistrement selon une ou plusieurs des revendications 1 à 4, **caractérisé en ce que** l'homopolymère ou le copolymère utilisé en tant que liant dans la couche sensible aux radiations a une masse moléculaire M_{w} dans la plage allant de 40 000 à 2 000 000, de préférence, de 50 000 à 1 000 000, de façon particulièrement préférée, de 80 000 à 500 000.

6. Matériau d'enregistrement selon une ou plusieurs des revendications 1 à 5, **caractérisé en ce que** la proportion du liant va de 5 à 40 % en poids, par rapport au poids total des composants non volatils de la couche sensible aux radiations.

7. Matériau d'enregistrement selon une ou plusieurs des revendications 1 à 6, **caractérisé en ce que** le produit de polycondensation de sel de diazonium est obtenu par condensation d'un composé de type diazonium aromatique polynucléaire, de préférence un sel de diphénylamine-4-diazonium substitué ou non substitué, avec un composé carbonyle actif, de préférence le méthoxyméthyldiphényléther ou le formaldéhyde.

8. Matériau d'enregistrement selon une ou plusieurs des revendications 1 à 7, **caractérisé en ce que** la couche sensible aux radiations en outre contient encore des colorants ou des plastifiants, de préférence, le glycérol.

9. Matériau d'enregistrement selon une ou plusieurs des revendications 1 à 8, **caractérisé en ce que** le poids de la couche sensible aux radiations va de 0,5 à 3,0 g/m², de préférence, de 0,8 à 1,5 g/m².

10. Matériau d'enregistrement selon une ou plusieurs des revendications 1 à 9, **caractérisé en ce que** la couche de silicone comprend un caoutchouc silicone de condensation.

11. Matériau d'enregistrement selon une ou plusieurs des revendications 1 à 10, **caractérisé en ce que** le poids de la couche de silicone va de 1,0 à 5,0, de préférence, de 1,2 à 3,5, de façon particulièrement préférée, de 1,5 à 3,0 g/m².

12. Matériau d'enregistrement selon une ou plusieurs des revendications 1 à 11, **caractérisé en ce qu'**une couche de matage discontinue se trouve sur la couche de silicone.

13. Matériau d'enregistrement selon la revendication 12, **caractérisé en ce que** la couche de matage est constituée d'un polymère organique soluble dans l'eau, de préférencé, de polyvinylpyrrolidone, poly(acide acrylique), polyvinylbutyral, polysaccharides, gélatine ou poly(alcool vinylique).

14. Matériau d'enregistrement selon une ou plusieurs des revendications 1 à 13, **caractérisé en ce que** le support consiste en aluminium ou en un alliage d'aluminium et sa surface est grainée électrochimiquement.

15. Procédé pour la fabrication d'une forme d'impression pour l'impression offset sans eau, **caractérisé en ce qu'**un matériau d'enregistrement selon une ou plusieurs des revendications 1 à 14 est insolé selon une image et ensuite développé avec de l'eau ou une solution aqueuse.
